# EUROPEAN PATENT APPLICATION

(11) **EP 4 095 700 A1**
(43) Date of publication of application: **30.11.2022**
(21) Application number: 22165530.1
(22) Date of filing: 30.03.2022
(51) Int. Cl.: G06F 11/36

(54) **METHOD AND SYSTEM FOR MICRO-SERVICE TESTING, AND STORAGE MEDIUM**

(30) Priority: 25.05.2021 CN 202110571038
(71) Applicant: Nio Technology (Anhui) Co., Ltd, Hefei City, Anhui 230601 (CN)
(72) Inventor: XIE, Yan, Hefei City, Anhui (CN); ZHAO, Dongxu, Hefei City, Anhui (CN); ZHU, Binqian, Hefei City, Anhui (CN); SUN, Fangli, Hefei City, Anhui (CN)
(74) Representative: Vossius & Partner Patentanwälte Rechtsanwälte mbB

(57) **Abstract**

This application relates to a method and system for micro-service testing, and a storage medium. The method for micro-service testing includes: performing simulation on a target micro-service based on machine learning; constructing a corresponding virtual micro-service based on a result of the simulation; initiating an invocation request for the target micro-service; redirecting the invocation request to the virtual micro-service; and returning a test result by the virtual micro-service in response to the invocation request. According to the method for micro-service testing, a virtual micro-service can be constructed by means of machine learning, to participate in testing and development in place of a real micro-service.

## Description

### Technical Field

This application relates to the field of computer development and testing, and in particular, to a method for micro-service testing, a system for micro-service testing, and a computer-readable storage medium.

### Background Art

Enterprises face problems, such as long links, unstable dependency micro-services, difficulties in terms of collaboration cycles, and occupation of too many software and hardware resources, during the practice of performance testing of system micro-services. Under the current architecture for interactions between multiple micro-service applications and multi-departmental micro-services in enterprises, performance testing requires advanced reservation of software/hardware resources, formulation of a test plan, development of test scripts, and coordination of resources among multiple departments, which will occupy a lot of time and resources of developers and testers. In addition, evaluation and testing environments in many business lines have been unable to meet requirements of performance testing. Then, performance testing is shifted to the right to a pre-release environment or even a production environment for implementation in the prior art, which may cause testing accidents due to data isolation or improper operations.

In view of this, there is a need to propose a machine learning-based performance testing solution for a micro-service to help developers and testers conduct performance testing of an individual micro-service more efficiently and intuitively, thus improving the efficiency of performance testing. In addition, an impact on the pre-release environment or the production environment may also be avoided.

### Summary of the Invention

Embodiments of this application provide a method for micro-service testing, a system for micro-service testing, and a computer-readable storage medium, so that a virtual micro-service can be constructed by means of machine learning, to participate in testing and development in place of a real micro-service.

According to an aspect of this application, a method for micro-service testing is provided, the method including: performing simulation on a target micro-service based on machine learning; constructing a corresponding virtual micro-service based on a result of the simulation; initiating an invocation request for the target micro-service; redirecting the invocation request to the virtual micro-service; and returning a test result by the virtual micro-service in response to the invocation request.

In some embodiments of this application, optionally, the simulation is performed on one or more interfaces of the target micro-service.

In some embodiments of this application, optionally, the constructed virtual micro-service includes a simulation model corresponding to one or more target micro-services.

In some embodiments of this application, optionally, each target micro-service corresponds to one or more simulation models, and where the target micro-service corresponds to a plurality of simulation models, the invocation request is initiated for each simulation model.

In some embodiments of this application, optionally, an input in training data for the machine learning includes at least some of the following items: a number of gateways in a link for the invocation request to the target micro-service, a number of processors of a server where the target micro-service is located, a request type of the invocation request, a number of parameters in the invocation request, a size of a body of the invocation request, a type of a return value corresponding to the invocation request, and whether the target micro-service executes the invocation request concurrently.

In some embodiments of this application, optionally, a target output from training data for the machine learning includes: a response time of the target micro-service to the invocation request.

According to another aspect of this application, a system for micro-service testing is provided, the system including: a virtual micro-service configured to receive an invocation request and store a simulation model constructed based on machine learning of a target micro-service, and configured to return a test result based on the invocation request and the simulation model; and a testing micro-service configured to receive a testing project and accordingly generate the invocation request for the target micro-service, and redirect the invocation request to the virtual micro-service.

In some embodiments of this application, optionally, the simulation is performed on one or more interfaces of the target micro-service.

In some embodiments of this application, optionally, the virtual micro-service includes a simulation model corresponding to one or more target micro-services.

In some embodiments of this application, optionally, each target micro-service corresponds to one or more simulation models, and where the target micro-service corresponds to a plurality of simulation models, the invocation request is generated for each simulation model.

In some embodiments of this application, optionally, an input in training data for the machine learning includes at least some of the following items: a number of gateways in a link for the invocation request to the target micro-service, a number of processors of a server where the target micro-service is located, a request type of the invocation request, a number of parameters in the invocation request, a size of a body of the invocation request, a type of a return value corresponding to the invocation request, and whether the target micro-service executes the invocation request concurrently.

In some embodiments of this application, optionally, a target output from training data for the machine learning includes: a response time of the target micro-service to the invocation request.

In some embodiments of this application, optionally, the virtual micro-service includes a database, the database storing the simulation model.

According to another aspect of this application, there is provided a computer-readable storage medium having stored therein instructions, where the instructions, when executed by a processor, cause the processor to perform any one of the methods for micro-service testing as described above.

### Brief Description of the Drawings

The above and other objectives and advantages of this application will be more thorough and clearer from the following detailed description in conjunction with the drawings, where the same or similar elements are represented by the same reference numerals.
FIG. 1 shows a method for micro-service testing according to an embodiment of this application.
FIG. 2 shows a system for micro-service testing according to an embodiment of this application.
FIG. 3 shows a principle of micro-service testing according to an embodiment of this application.
FIG. 4 shows a principle of machine learning according to an embodiment of this application.

### Detailed Description of Embodiments

For the sake of brevity and illustrative purposes, the principles of this application are mainly described herein with reference to its exemplary embodiments. However, those skilled in the art would readily appreciate that the same principles may be equivalently applied to all types of methods for micro-service testing, systems for micro-service testing, and computer-readable storage media, and these same or similar principles may be implemented therein. These variations do not depart from the true spirit and scope of this application.

In the context of this application, various "micro-services" generally refer to entities including hardware and software that can physically exist and are capable of providing various services.

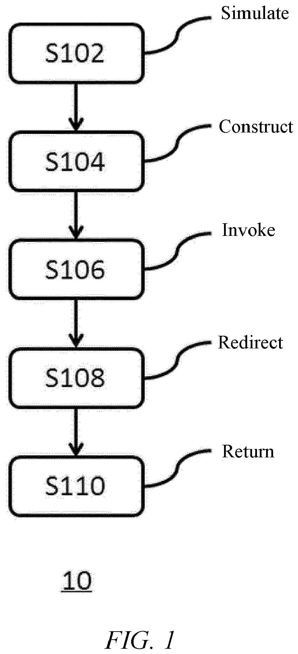

According to an aspect of this application, a method for micro-service testing is provided. As shown in FIG. 1, a method 10 for micro-service testing includes the process as follows. The method 10 for micro-service testing involves performing simulation on a target micro-service based on machine learning in step S102, constructing a corresponding virtual micro-service based on a result of the simulation in step S104, initiating an invocation request for the target micro-service in step S106, redirecting the invocation request to the virtual micro-service in step S108, and returning a test result by the virtual micro-service in response to the invocation request in step S 110.

It should be noted that, in some cases, some steps of the method 10 for micro-service testing shown in FIG. 1 may be changed in order, and some steps thereof may be performed simultaneously. The scope of protection of the invention is not limited to the embodiment shown in FIG. 1.

In step S 102 of the method 10 for micro-service testing, the simulation is performed, in advance, on the target micro-service at which testing is actually targeted, and this simulation is performed based on the machine learning. Compared with conventional simulation methods, simulation results for machine learning are relatively robust, and can adapt to various application scenarios. Conventional simulation usually relies more on experience, and its simulation results are more subjected to human influence. By performing simulation using a machine learning method, various subjective biases can be overcome, and relatively accurate predictions can also be made for scenarios that cannot be covered by experience.

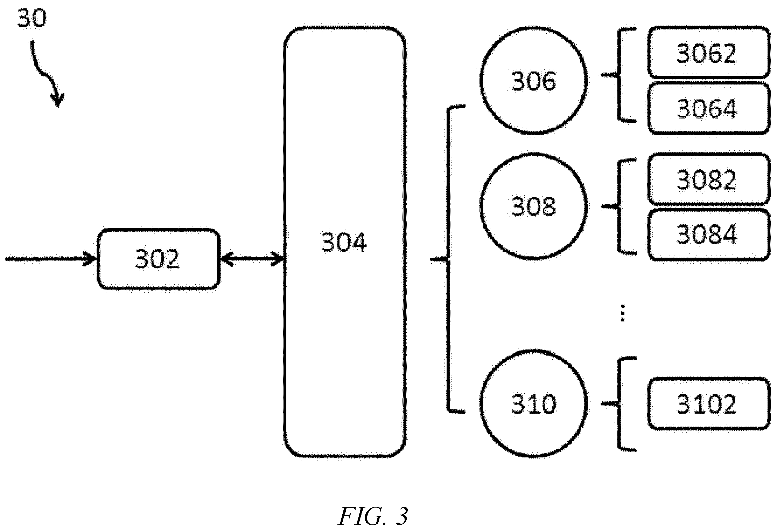

In some embodiments of this application, the simulation may be performed on one or more interfaces of the target micro-service simultaneously. The target micro-service may have more than one interface, and some or all of the interfaces of the target micro-service may be simulated according to testing requirements. Each interface participating in the simulation has a corresponding virtual interface in a virtual service. Referring to FIG. 3, for example, a target micro-service 306 is the target micro-service at which testing is actually targeted. According to testing requirements, in step S102, instead of simulating all interfaces of the target micro-service 306, only an interface (e.g., an interface 3062) invoked by a testing micro-service 302 may be simulated. Similarly, in step S102, an interface 3084 of a target micro-service 308, or an interface 3102 of a target micro-service 310 may also be simulated as desired.

In step S104 of the method 10 for micro-service testing, the corresponding virtual micro-service is constructed based on the result of the simulation, and the virtual micro-service can, in place of an actual target micro-service, participate in a testing project that will be described below. Participating in testing by using the virtual micro-service may prevent initiating testing directly to the actual micro-service, thus avoiding damage to an actual operating environment. For example, as shown in FIG. 3, the simulation result for the target micro-service 306 (or some of the interfaces thereof) may be implemented by a virtual micro-service 304. In the following steps, the virtual micro-service 304 will participate in the testing in place of the target micro-service 306 (or some of the interfaces thereof), so as to prevent some items in the testing from damaging the actual environment.

In some embodiments of this application, the constructed virtual micro-service includes a simulation model corresponding to one or more target micro-services. In some examples, a testing micro-service may invoke data from a plurality of (third-party) target micro-services to provide services. To this end, the plurality of target micro-services that may be invoked can be constructed in a service body according to the testing requirements. The virtual micro-service may include simulation models corresponding to these target micro-services, and each target micro-service (or an interface thereof) may correspond to more than one simulation model. For example, referring to FIG. 3, the testing micro-service 302 may invoke data from the micro-service 306 and the micro-service 308. Further, the testing micro-service 302 invokes the data from the micro-service 306 through an interface 3064, and invokes the data from the micro-service 308 through an interface 3082. In this case, the virtual micro-service 304 may include i simulation models corresponding to the interface 3064 of the micro-service 306; and the virtual micro-service 304 may include j simulation models corresponding to the interface 3082 of the micro-service 308.

In some examples of this application, the purpose of simulation performance testing is achieved in a manner of continuously approximating the response and delay of an online dependency service. In addition, the tolerance with and performance regarding the dependency service are verified using various varying models, aiming to observe the availability and actual performance of a micro-service under test in the case of the dependency service being variable.

In step S 106 of the method 10 for micro-service testing, the invocation request for the target micro-service is initiated. An external program first initiates a test request to a testing micro-service, and the testing micro-service then initiates an invocation request for the target micro-service based on the test request. There may be more than one target micro-service, and at least one interface of the target micro-service may be tested. For example, continuing with the example of FIG. 3, the testing micro-service 302 receives a test request from the outside and initiates an invocation request for the target micro-services 306 and 308. The testing micro-service 302 invokes data through the interface 3064 of the target micro-service 306 and the interface 3082 of the target micro-service 308. Therefore, the invocation request is generated for the interface 3064 of the target micro-service 306 and the interface 3082 of the target micro-service 308.

In some embodiments of this application, each target micro-service corresponds to one or more simulation models, and where the target micro-service corresponds to a plurality of simulation models, the invocation request is initiated for each simulation model. Continuing with the above example, since the virtual micro-service 304 includes i simulation models corresponding to the interface 3064 of the service 306 and j simulation models corresponding to the interface 3082 of the service 308, a total of at least k = max(i, j) invocation requests need to be initiated to ensure that each model participates in the testing.

In step S 108 of the method 10 for micro-service testing, the invocation request is redirected to the virtual micro-service. As previously described, the virtual micro-service participates in the testing project in place of the actual target micro-service in some examples of the invention. For example, a destination address of the invocation request can be rewritten to an address of the virtual micro-service, thereby ensuring that when the testing micro-service initiates an invocation request to the target micro-service, the relevant invocation request will be forwarded to the virtual micro-service. For example, continuing with the above example, the k invocation requests will be redirected to the virtual micro-service 304. The virtual micro-service 304 will participate in the testing in place of the actual target micro-service 306 (the interface 3064 thereof) and target micro-service 308 (the interface 3082 thereof).

In step S110 of the method 10 for micro-service testing, the test result is returned by the virtual micro-service in response to the invocation request. For example, the test result can at least reflect a response time of the service, so that the performance of the testing micro-service can be evaluated. Some examples of the invention do not focus on actual content of the returned test result, which actual content may not necessarily be related to performance testing itself. For example, continuing with the above example, since a total of k invocation requests are executed at the virtual micro-service 304, the virtual micro-service 304 will return k test results to the testing micro-service 302, and thus, k service response times can be deduced. In some examples, an average value of the c response times can be taken as a final evaluated response time.

In some embodiments of this application, an input in training data for the machine learning may include some or all of the following items (in some examples, all of the following items may be included so that the reliability of simulation may be ensured): a number of gateways in a link for the invocation request to the target micro-service, a number of processors of a server where the target micro-service is located, a request type of the invocation request, a number of parameters in the invocation request, a size of a body of the invocation request, a type of a return value corresponding to the invocation request, and whether the target micro-service executes the invocation request concurrently. A target output from training data for the machine learning includes: a response time of the target micro-service to the invocation request.

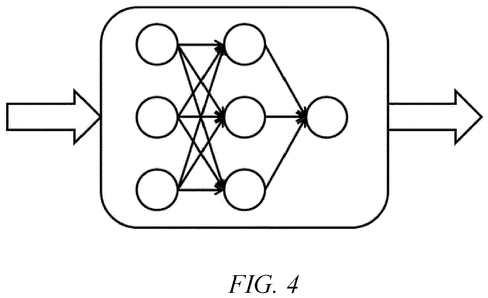

FIG. 4 shows a principle of machine learning according to an example of the invention. At the left-side input, some or all of the number of gateways in a link for the invocation request to the target micro-service, the number of processors of a server where the target micro-service is located, the request type of the invocation request, the number of parameters in the invocation request, the size of a body of the invocation request, the type of a return value corresponding to the invocation request, and whether the target micro-service executes the invocation request concurrently as described above may be received. At the right-side target output, a response time, etc. of a target server (an interface thereof) to the invocation request can be used as the target output for training. Participating in training in the form of a neural network is shown in FIG. 4, and in other examples, machine learning may also be performed in other feasible ways. The trained neural network will be configured, as a simulation model, into the virtual micro-service, and the virtual micro-service may then give, based on an invocation request in a testing project, a test result that can reflect a response time of the service.

In some of the above examples, learning and training of an online service interface that a micro-service to be subjected to performance testing depends on are performed based on a machine learning model, so that a response time prediction model may be obtained for the online service interface. An interface simulation service further generates, by using predicted response data for the dependency interface that is returned by the machine learning model, predicted response data for the online service interface that the service under test depends on, so as to provide a condition for performance testing of an individual micro-service.

In some of the above examples, on the basis of machine learning, possible performance, at higher traffic, of a dependency service can be predicted based on a relationship between online historical traffic/times/services, and a prediction capability beyond online simulation can be achieved. In some of the above examples, a brand-new method for performance testing is provided in combination with the field of machine learning, which method features a short link, a single node, no dependency, higher flexibility, a variable and controllable scenario, and predictability.

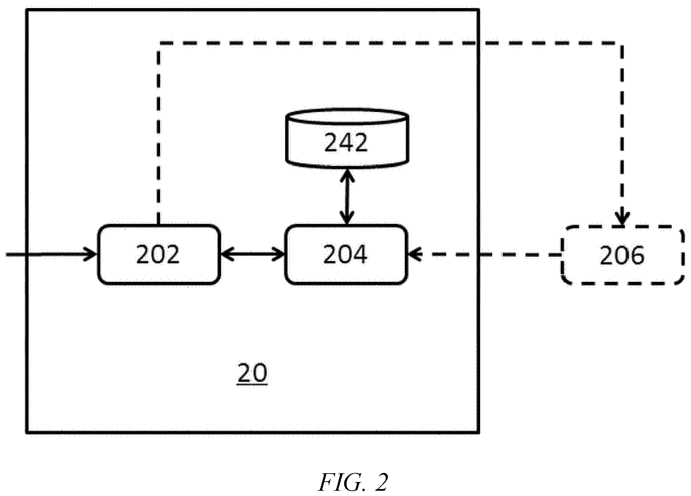

According to another aspect of this application, a system for micro-service testing is provided. As shown in FIG. 2, a system 20 for micro-service testing includes a testing micro-service 202 and a virtual micro-service 204. In addition, for the purpose of clearly illustrating the principles of the invention, a target micro-service 206 is also shown in FIG. 2.

In an embodiment shown in FIG. 2, the virtual micro-service 204 is configured to receive an invocation request and store a simulation model constructed based on machine learning of a target micro-service, and configured to return a test result based on the invocation request and the simulation model. In addition, the testing micro-service 202 is configured to receive a testing project and accordingly generate the invocation request for the target micro-service, and redirect the invocation request to the virtual micro-service 204.

The virtual micro-service 204 of the system 20 for micro-service testing is configured to store a simulation model for the target micro-service 206 at which testing is actually targeted, and this simulation is performed based on machine learning. Compared with conventional simulation methods, simulation results for machine learning are relatively robust, and can adapt to various application scenarios. Conventional simulation usually relies more on experience, and its simulation results are more subjected to human influence. By performing simulation using a machine learning method, various subjective biases can be overcome, and relatively accurate predictions can also be made for scenarios that cannot be covered by experience.

In some embodiments of this application, the simulation may be performed on one or more interfaces of the target micro-service simultaneously. The target micro-service may have more than one interface, and some or all of the interfaces of the target micro-service may be simulated according to testing requirements. Each interface participating in the simulation has a corresponding virtual interface in a virtual service. Referring to FIG. 3, for example, a target micro-service 306 is the target micro-service at which testing is actually targeted. According to testing requirements, instead of simulating all interfaces of the target micro-service 306, only an interface (e.g., an interface 3062) invoked by a testing micro-service 302 may be simulated.

The virtual micro-service 204 of the system 20 for micro-service testing is constructed based on the result of the simulation. In other words, a corresponding simulation model may be stored in the virtual micro-service 204, so that the virtual micro-service 204 can, in place of the actual target micro-service 206, participate in a testing project that will be described below. Participating in testing by using the virtual micro-service 204 may prevent initiating testing directly to the actual micro-service 206, thus avoiding damage to an actual operating environment. For another example, referring to FIG. 3, the simulation result for the target micro-service 306 (or some of the interfaces thereof) may be implemented by a virtual micro-service 304. In the following steps, the virtual micro-service 304 will participate in the testing in place of the target micro-service 306 (or some of the interfaces thereof), so as to prevent some items in the testing from damaging the actual environment.

In some embodiments of this application, the constructed virtual micro-service 204 includes a simulation model corresponding to one or more target micro-services. In some examples, a testing micro-service 202 may invoke data from a plurality of (third-party) target micro-services to provide services. To this end, the plurality of target micro-services that may be invoked can be constructed in a service body according to the testing requirements. The virtual micro-service 204 may include simulation models corresponding to these target micro-services, and each target micro-service (or interfaces thereof) may correspond to more than one simulation model. For example, referring to FIG. 3, the testing micro-service 302 may invoke data from the micro-service 306 and the micro-service 308. Further, the testing micro-service 302 invokes the data from the micro-service 306 through an interface 3064, and invokes the data from the micro-service 308 through an interface 3082. In this case, the virtual micro-service 304 may include i simulation models corresponding to the interface 3064 of the micro-service 306; and the virtual micro-service 304 may include j simulation models corresponding to the interface 3082 of the micro-service 308.

In some examples of this application, the purpose of simulation performance testing is achieved in a manner of continuously approximating the response and delay of an online dependency service. In addition, the tolerance with and performance regarding the dependency service are verified using various varying models, aiming to observe the availability and actual performance of a micro-service under test in the case of the dependency service being variable.

In some examples, an external program first initiates a test request to the testing micro-service 202, and the testing micro-service 202 then initiates an invocation request for the target micro-service 206 based on the test request. There may be more than one target micro-service, and at least one interface of the target micro-service may be tested. For example, continuing with the example of FIG. 3, the testing micro-service 302 receives a test request from the outside and initiates an invocation request for the target micro-services 306 and 308. The testing micro-service 302 invokes data through the interface 3064 of the target micro-service 306 and the interface 3082 of the target micro-service 308. Therefore, the invocation request is generated for the interface 3064 of the target micro-service 306 and the interface 3082 of the target micro-service 308.

In some embodiments of this application, each target micro-service corresponds to one or more simulation models, and where the target micro-service corresponds to a plurality of simulation models, the invocation request is initiated for each simulation model. Continuing with the above example, since the virtual micro-service 304 includes i simulation models corresponding to the interface 3064 of the service 306 and j simulation models corresponding to the interface 3082 of the service 308, a total of at least k = max(i, j) invocation requests need to be initiated to ensure that each model participates in the testing.

The testing micro-service 202 of the system 20 for micro-service testing redirects the invocation request to the virtual micro-service 204. As previously described, the virtual micro-service 204 participates in the testing project in place of the actual target micro-service 206 in some examples of the invention. For example, a destination address of the invocation request can be rewritten to an address of the virtual micro-service 204, thereby ensuring that when the testing micro-service 202 initiates an invocation request to the target micro-service, the relevant invocation request will be forwarded to the virtual micro-service 204. For example, continuing with the above example, the k invocation requests will be redirected to the virtual micro-service 304. The virtual micro-service 304 will participate in the testing in place of the actual target micro-service 306 (the interface 3064 thereof) and target micro-service 308 (the interface 3082 thereof).

The virtual micro-service 204 of the system 20 for micro-service testing is configured to return a test result based on the invocation request and the simulation model. For example, the test result can at least reflect a response time of the service, so that the performance of the testing micro-service 202 can be evaluated. Some examples of the invention do not focus on actual content of the returned test result, which actual content may not necessarily be related to performance testing itself. For example, continuing with the above example, since a total of k invocation requests are executed at the virtual micro-service 304, the virtual micro-service 304 will return k test results to the testing micro-service 302, and thus, k service response times can be deduced. In some examples, an average value of the c response times can be taken as a final evaluated response time.

In some embodiments of this application, an input in training data for the machine learning may include some or all of the following items (in some examples, all of the following items may be included so that the reliability of simulation may be ensured): a number of gateways in a link for the invocation request to the target micro-service, a number of processors of a server where the target micro-service is located, a request type of the invocation request, a number of parameters in the invocation request, a size of a body of the invocation request, a type of a return value corresponding to the invocation request, and whether the target micro-service executes the invocation request concurrently. A target output from training data for the machine learning includes: a response time of the target micro-service to the invocation request.

FIG. 4 shows a principle of machine learning according to an example of the invention. At the left-side input, some or all of the number of gateways in a link for the invocation request to the target micro-service, the number of processors of a server where the target micro-service is located, the request type of the invocation request, the number of parameters in the invocation request, the size of a body of the invocation request, the type of a return value corresponding to the invocation request, and whether the target micro-service executes the invocation request concurrently as described above may be received. At the right-side target output, a response time, etc. of a target server (an interface thereof) to the invocation request can be used as the target output for training. Participating in training in the form of a neural network is shown in FIG. 4, and in other examples, machine learning may also be performed in other feasible ways. The trained neural network will be configured, as a simulation model, into the virtual micro-service 204, and the virtual micro-service 204 may then give, based on an invocation request in a testing project, a test result that can reflect a response time of the service.

In some embodiments of this application, the virtual micro-service 204 includes a database 242, the database 242 storing the simulation model. For example, an external program initiates a test request by invoking an interface/A/x of a testing micro-service 202, and the testing micro-service 202 then makes a request to the virtual micro-service 204 by invoking an interface/B/y. The virtual micro-service 204 obtains, based on the simulation model in the database 242, a response time T generated based on machine learning. The virtual micro-service 204 may make a response time at the interface/B/y equal to the stored response time T by using a method of invoking a thread sleep.

In some of the above examples, learning and training of an online service interface that a micro-service to be subjected to performance testing depends on are performed based on a machine learning model, so that a response time prediction model may be obtained for the online service interface. An interface simulation service further generates, by using predicted response data for the dependency interface that is returned by the machine learning model, predicted response data for the online service interface that the service under test depends on, so as to provide a condition for performance testing of an individual micro-service.

In some of the above examples, on the basis of machine learning, possible performance, at higher traffic, of a dependency service can be predicted based on a relationship between online historical traffic/times/services, and a prediction capability beyond online simulation can be achieved. In some of the above examples, a brand-new method for performance testing is provided in combination with the field of machine learning, which method features a short link, a single node, no dependency, higher flexibility, a variable and controllable scenario, and predictability.

According to another aspect of this application, there is provided a computer-readable storage medium having stored therein instructions, where the instructions, when executed by a processor, cause the processor to perform any one of the methods for micro-service testing as described above. The computer-readable medium in this application includes various types of computer storage media, and may be any usable medium accessible to a general-purpose or special-purpose computer. For example, the computer-readable medium may include a RAM, a ROM, an EPROM, an E²PROM, a register, a hard disk, a removable hard disk, a CD-ROM or another optical memory, a magnetic disk memory or another magnetic storage device, or any other transitory or non-transitory media that can carry or store expected program code having an instruction or data structure form and be accessible to the general-purpose or special-purpose computer or a general-purpose or special-purpose processor. As used herein, data is usually copied magnetically in a disk, while data is usually copied optically by using lasers in a disc. A combination thereof shall also fall within the scope of protection of the computer-readable media. For example, the storage medium is coupled to a processor, so that the processor can read information from and write information to the storage medium. In an alternative solution, the storage medium may be integrated into the processor. The processor and the storage medium may reside in an ASIC. The ASIC may reside in a user terminal. In an alternative solution, the processor and the storage medium may reside, as discrete assemblies, in a user terminal.

The foregoing descriptions are merely the embodiments of this application, but are not intended to limit the scope of protection of this application. Any feasible variation or replacement conceived by a person skilled in the art within the technical scope disclosed in this application shall fall within the scope of protection of this application. In the case of no conflict, the embodiments of this application and features in the embodiments may also be combined with one another. The scope of protection of this application shall be subject to recitations of the claims.

## Claims

1. A method for micro-service testing, comprising:
performing simulation on a target micro-service based on machine learning;
constructing a corresponding virtual micro-service based on a result of the simulation;
initiating an invocation request for the target micro-service;
redirecting the invocation request to the virtual micro-service; and
returning a test result by the virtual micro-service in response to the invocation request.

2. The method according to claim 1, wherein the simulation is performed on one or more interfaces of the target micro-service.

3. The method according to claim 1 or 2, wherein the constructed virtual micro-service comprises a simulation model corresponding to one or more target micro-services.

4. The method according to claim 3, wherein each target micro-service corresponds to one or more simulation models, and where the target micro-service corresponds to a plurality of simulation models, the invocation request is initiated for each simulation model.

5. The method according to any one of claims 1 to 4, wherein an input in training data for the machine learning comprises at least some of the following items:
a number of gateways in a link for the invocation request to the target micro-service, a number of processors of a server where the target micro-service is located, a request type of the invocation request, a number of parameters in the invocation request, a size of a body of the invocation request, a type of a return value corresponding to the invocation request, and whether the target micro-service executes the invocation request concurrently.

6. The method according to any one of claims 1 to 5, wherein a target output from training data for the machine learning comprises: a response time of the target micro-service to the invocation request.

7. A system for micro-service testing, preferably being adapted to perform the method of any one of claims 1 to 6, the system comprising:
a virtual micro-service configured to receive an invocation request and store a simulation model constructed based on machine learning of a target micro-service, and configured to return a test result based on the invocation request and the simulation model; and
a testing micro-service configured to receive a testing project and accordingly generate the invocation request for the target micro-service, and redirect the invocation request to the virtual micro-service.

8. The system according to claim 7, wherein the simulation is performed on one or more interfaces of the target micro-service.

9. The system according to claim 7 or 8, wherein the virtual micro-service comprises a simulation model corresponding to one or more target micro-services.

10. The system according to claim 9, wherein each target micro-service corresponds to one or more simulation models, and where the target micro-service corresponds to a plurality of simulation models, the invocation request is generated for each simulation model.

11. The system according to any one of claims 7 to 10, wherein an input in training data for the machine learning comprises at least some of the following items: a number of gateways in a link for the invocation request to the target micro-service, a number of processors of a server where the target micro-service is located, a request type of the invocation request, a number of parameters in the invocation request, a size of a body of the invocation request, a type of a return value corresponding to the invocation request, and whether the target micro-service executes the invocation request concurrently.

12. The system according to any one of claims 7 to 11, wherein a target output from training data for the machine learning comprises: a response time of the target micro-service to the invocation request.

13. The system according to any one of claims 7 to 12, wherein the virtual micro-service comprises a database, the database storing the simulation model.

14. A computer-readable storage medium having stored therein instructions, wherein the instructions, when executed by a processor, cause the processor to perform a method for micro-service testing, preferably the method of any one of claims 1 to 6, the method comprising:
performing simulation on a target micro-service based on machine learning;
constructing a corresponding virtual micro-service based on a result of the simulation;
initiating an invocation request for the target micro-service;
redirecting the invocation request to the virtual micro-service; and
returning a test result by the virtual micro-service in response to the invocation request.
